# FASCICULE DE BREVET EUROPEEN

(11) **EP 3 385 965 B1**
(45) Date de publication et mention de la délivrance du brevet: **05.08.2020**
(21) Numéro de dépôt: 18165815.4
(22) Date de dépôt: 05.04.2018
(51) Int. Cl.: H01F 41/082, H01F 41/088, H01F 41/02

(54) **TÊTE DE BOBINAGE POUR UNE MACHINE DE BOBINAGE TOROÏDAL, MACHINE DE BOBINAGE TOROÏDAL COMPRENANT UNE TELLE TÊTE DE BOBINAGE ET PROCÉDÉ**
WICKLUNGS-KOPF FÜR EINE TOROIDAL-WICKELMASCHINE, TOROIDAL-WICKELMASCHINE BESTEHEND AUS SOLCHEM WICKLUNGS-KOPF UND PROZESS
WINDING HEAD FOR A TOROIDAL WINDING MACHINE, TOROIDAL WINDING MACHINE COMPRISING SUCH A WINDING HEAD AND PROCESS

(30) Priorité: 06.04.2017 FR 1752997
(43) Date de publication de la demande: 10.10.2018
(73) Titulaire: Schneider Electric Industries SAS, 92500 Rueil-Malmaison (FR)
(72) Inventeur: GERY, Frédéric, 38050 GRENOBLE Cedex 09 (FR); BRUNEL, Philippe, 38050 GRENOBLE Cedex 09 (FR); GRANIER, David, 38050 GRENOBLE Cedex 09 (FR); PELLETIER, Michel, 38050 GRENOBLE Cedex 09 (FR)
(74) Mandataire: Lavoix

(56) Documents cités:
- EP-A1- 0 225 316
- FR-A1- 2 474 468
- US-A- 263 780
- US-A- 302 627
- US-A- 700 713
- US-A- 802 359
- US-A1- 2001 015 393
- US-A1- 2005 242 227

## Description

La présente invention concerne une tête de bobinage pour une machine de bobinage toroïdal. Une telle machine permet notamment la réalisation de tores bobinés pour l'obtention de capteurs de courant à haut niveau de précision.

De manière connue, une machine de bobinage toroïdal comprend une table de bobinage et une tête de bobinage. La table de bobinage supporte le tore à bobiner. Elle comprend des moyens pour entrainer le tore en rotation autour de son axe. La tête de bobinage est l'organe de la machine permettant de bobiner le tore, c'est-à-dire d'enrouler un fil de cuivre sur toute la circonférence du tore.

Dans ce domaine, la société RUFF GmbH exploite notamment une machine de dénomination « RWE Evolution ». La tête de bobinage de cette machine comprend ce qu'on appelle un magasin, qui est une pièce annulaire utilisée pour stocker la quantité de fil nécessaire au bobinage du tore. Notamment, le fil est enroulé à l'intérieur d'une gorge périphérique du magasin. Dans cet exemple, le magasin comprend un tronçon amovible pour permettre le passage du tore.

La tête de bobinage comprend également ce qu'on appelle un curseur, qui est une pièce rapportée sur un flanc du magasin et qui possède deux fonctions. La première fonction du curseur est de guider le fil de bobinage, en sortie du magasin, autour du tore à bobiner. A cet effet, Le curseur comporte une rainure pour le passage du fil de bobinage. L'autre fonction du curseur est de mettre le fil de bobinage en tension. Dans cet exemple, le magasin et le curseur sont liés l'un à l'autre par une liaison en queue d'aronde : le curseur comprend un tenon en forme de trapèze, qui est engagé à l'intérieur d'une rainure périphérique correspondante formée sur un flanc du magasin. Le curseur comprend par ailleurs une corde, du type corde à piano, qui génère par frottement à l'intérieur de la rainure un couple de trainée permanent.

Le fonctionnement de cette machine est le suivant. D'abord, le tronçon amovible du magasin est retiré de façon à pouvoir positionner la section du tore à bobiner globalement au centre du magasin. Puis, le tronçon est remis en place. Ensuite, une extrémité du fil est attachée au magasin et le magasin est mis en rotation, de façon à enrouler la quantité de fil de bobinage nécessaire au bobinage du tore. On parle d'une phase de chargement du magasin. Une fois cette opération de chargement effectuée, le fil est coupé. L'extrémité libre du fil est passée autour d'un élément du tore, tel qu'une broche ou un segment du tore en exécutant quelques tours morts puis est immobilisée grâce à un système de suspente. Le bobinage peut alors commencer. Pour cela, le magasin est mis en rotation, ce qui a pour effet de mettre le fil sous tension. La tension du fil entraine le déplacement du curseur le long du magasin, et donc autour de la section du tore à bobiner. Le tore est entrainé en rotation de façon synchronisée, de manière à obtenir un bobinage sur toute la circonférence. Le fil est maintenu en tension pendant toute l'opération de bobinage grâce aux frottements de la corde à piano qui freine le déplacement du curseur.

Cette machine présente plusieurs inconvénients. Premièrement, le magasin et le curseur s'usent rapidement du fait des frottements occasionnés par la liaison en queue d'aronde et doivent donc être remplacés fréquemment. Cela nécessite également un rodage du nouveau couple magasin/curseur (générant ainsi un appairage forcé) puis la reprise des programmes de bobinage pour s'adapter aux nouvelles conditions mécaniques de la machine. En outre, le déplacement du curseur le long du magasin génère de la poussière. Ainsi, l'entretien de la machine (nettoyage et remplacement des pièces d'usure) est relativement couteux.

Deuxièmement, la tension du fil pendant l'opération de bobinage ne peut pas être contrôlée. Effectivement, la valeur de tension est imposée par les caractéristiques de l'assemblage entre le magasin et le curseur, et notamment par les efforts de frottement entre le curseur et le magasin. Il n'est donc pas possible d'ajuster la valeur de tension en fonction du diamètre du fil à bobiner par exemple. Troisièmement, les curseurs étant des pièces façonnées manuellement, leurs dimensions et leur forme sont variables d'une pièce à l'autre. Cela entraine des dispersions au niveau de la valeur de tension du fil de bobinage, et donc une mauvaise répétabilité. La qualité de bobinage, c'est-à-dire la régularité de la dépose des spires (le pas), est, elle aussi, variable.

US 802 359 divulgue une tête de bobinage pour une machine de bobinage toroïdal, comprenant un magasin annulaire et un curseur en forme de poulie. Le curseur fait partie d'un anneau. Le magasin et l'anneau sont montés côte à côte, de façon à pouvoir tourner indépendamment l'un de l'autre.

US 302 627 divulgue une tête de bobinage pour une machine de bobinage toroïdal. La tête de bobinage comprend un magasin annulaire et un curseur, formé par des poulies. Ces poulies sont montées respectivement autour d'axes fixés à un anneau monté à l'intérieur d'un flasque, et entrainé en rotation grâce à un pignon. Le magasin est également solidaire de l'anneau. Il n'y a pas de moyens d'entrainement indépendants pour le curseur et le magasin, et le curseur n'est pas fixé sur un flanc d'une roue montée coaxialement à l'intérieur du magasin.

C'est à ces inconvénients qu'entend plus particulièrement remédier l'invention en proposant une machine de bobinage permettant de contrôler la valeur de tension du fil de bobinage et avec un coût d'entretien moindre.

L'invention concerne une machine de bobinage toroïdal telle que définie dans la revendication 1.

Grâce à l'invention, la valeur de tension du fil de bobinage peut être contrôlée en ajustant la vitesse du curseur par rapport à celle du magasin. La même valeur de tension peut alors être utilisée pour chaque tore d'une série (caractère répétable), si bien que tous les tores bobinés présentent la même régularité en ce qui concerne le positionnement des spires et donc la même qualité de bobinage.

De plus, le curseur et le magasin sont indépendant mécaniquement l'un de l'autre et ne frottent plus l'un contre l'autre pendant l'opération de bobinage. Ainsi, le magasin et le curseur ne s'usent pas, ou quasiment pas et il n'est pas nécessaire de les remplacer périodiquement.

Egalement, la tension de bobinage peut être changée pendant le cycle. Cela est notamment bénéfique lorsque le tore comporte plusieurs couches de fil. Effectivement, des développements ont montré que la tension du fil de la deuxième couche doit de préférence être plus faible que celle de la première couche, de façon à limiter l'impact du dépôt de la deuxième couche sur la première couche, et donc de l'imbrication des spires.

Selon des aspects avantageux, mais non obligatoires de l'invention, une telle machine peut incorporer une ou plusieurs des caractéristiques, prises dans toute combinaison techniquement admissible, définies dans les revendications 2 à 7.

L'invention concerne enfin un procédé de bobinage d'un tore au moyen d'une machine telle que définie précédemment, le procédé comprenant des étapes telles que définies à la revendication 8.

L'invention et d'autres avantages de celle-ci apparaitront plus clairement à la lumière de la description qui va suivre de trois modes de réalisation d'une tête de bobinage conforme à son principe, donnée uniquement à titre d'exemple et faite en référence aux dessins annexés dans lesquels :
- la figure 1 est une vue en perspective d'une machine de bobinage toroïdal, comprenant une tête de bobinage conforme à l'invention,
- la figure 2 est une vue en perspective de la tête de bobinage représentée seule,
- la figure 3 est une vue partielle et de côté de la tête de bobinage de la figure 2,
- la figure 4 est une vue en perspective d'un magasin appartenant à la tête de bobinage des figures 2 et 3,
- la figure 5 est une vue en perspective d'une roue de fixation d'un curseur appartenant à la tête de bobinage des figures 2 et 3,
- la figure 6 est une vue en perspective d'un second mode de réalisation d'une tête de bobinage conforme à l'invention,
- la figure 7 est une vue en coupe d'un magasin appartenant à la tête de bobinage de la figure 6,
- la figure 8 est une vue à plus grande échelle de l'encerclé VIII de la figure 7,

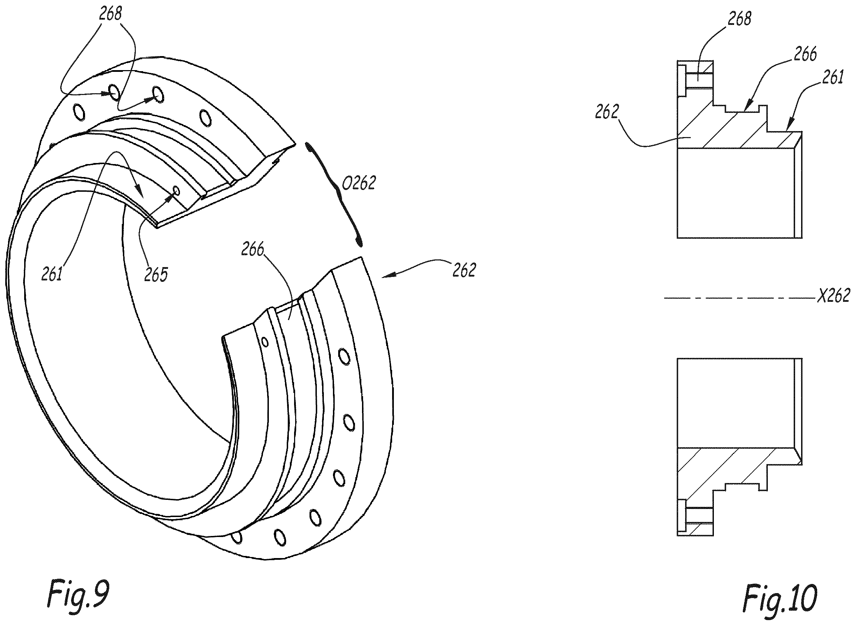

- la figure 9 est une vue en perspective d'une roue pour la fixation du curseur appartenant à la tête de bobinage de la figure 6,
- la figure 10 est une vue en coupe de la roue de la figure 9,
- la figure 11 est une vue en perspective de la table de bobinage de la machine de bobinage toroïdale de la figure 1,
- la figure 12 est une vue en perspective d'une pince concentrique appartenant à la table de bobinage de la figure 11,
- la figure 13 est une vue de côté montrant notamment une pince de préhension d'un tore à bobiner,
- la figure 14 est une vue en perspective d'une tête de bobinage conforme à un troisième mode de réalisation de l'invention, et
- les figures 15 et 16 sont des vues de côté d'un ensemble magasin-curseur appartenant à la tête de bobinage de la figure 14.

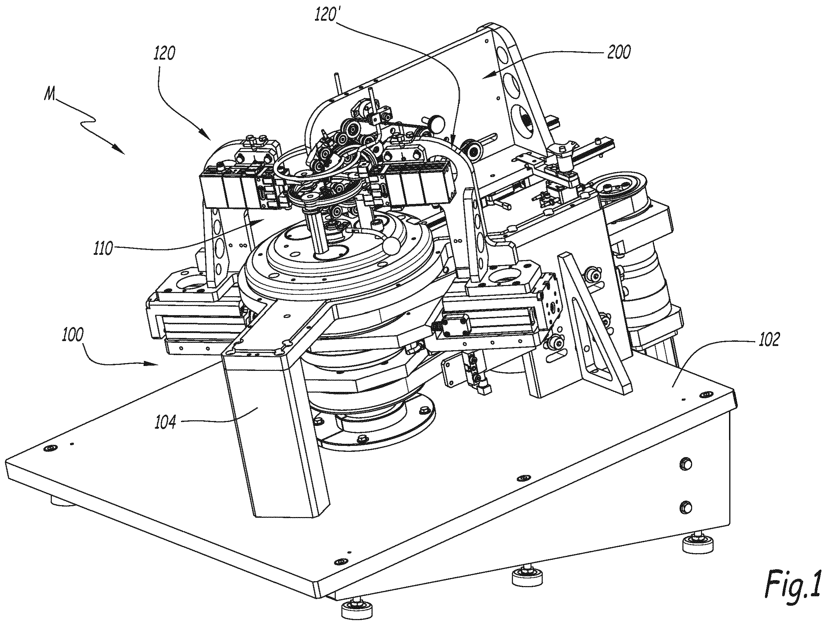

La figure 1 représente une machine de bobinage toroïdal M, permettant la réalisation de tores bobinés destinés à la confection de capteurs de mesure de courant. Un tore bobiné comprend un support de forme torique et un bobinage en fil conducteur, notamment en fil de cuivre, qui est enroulé autour du support. Pour la réalisation d'un tel tore bobiné, le support doit être entrainé en rotation autour de son axe de façon à enrouler du fil de bobinage sur toute sa circonférence.

La machine M comprend une table de bobinage 100 pour supporter et mettre en rotation un support torique T autour de son axe et une tête de bobinage 200 pour effectuer l'opération de bobinage à strictement parler. La table de bobinage 100 comprend un support incliné 102.

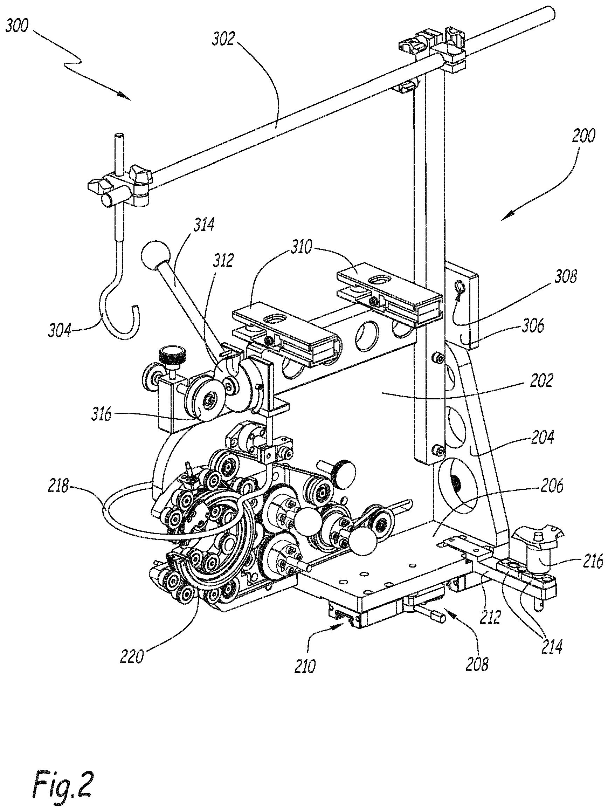

Comme visible à la figure 2, la tête de bobinage 200 comprend une plaque support 206, en dessous de laquelle sont fixés quatre guides linéaires 210, dont seulement deux sont représentés à la figure 2. Les guides linéaires 210 permettent de positionner la tête de bobinage 200 par rapport à la table de bobinage 100. Dans l'exemple, les guides linéaires 210 sont des patins à recirculation de billes conférant une forte capacité de charge.

Un frein 208 est interposé entre deux des patins 210. Le frein 208 dispose d'un levier d'actionnement.

Un bras 212, s'étendant dans le même plan que la plaque support 206, porte deux manchons 214 délimitant chacun un trou oblong de passage d'une goupille 216. La goupille 216 permet d'immobiliser en translation la tête de bobinage 200 par rapport à la table de bobinage 100.

La tête de bobinage 200 comprend également une plaque verticale 202, qui est perpendiculaire à la plaque support 206 et sur laquelle sont fixés tous les composants nécessaires au bobinage du tore. Notamment, la plaque verticale 202 supporte un magasin 220, dont la fonction est de stocker la quantité de fil nécessaire au bobinage d'un tore.

La machine de bobinage toroïdal M comprend un système 300 pour amener du fil de bobinage à partir d'une bobine mère (non représentée) située derrière la machine M jusqu'au magasin 220. Dans l'exemple, la bobine mère est installée sur un plateau coulissant.

Le système 300 comprend plusieurs composants de guidage, et notamment une plaque 306 délimitant un orifice 308 de passage du fil et deux organes de guidage 310 disposés entre la plaque 306 et un système coupe-fil 312, lequel pouvant être actionné manuellement au moyen d'un levier 314. Enfin, le système 300 comprend, à la fin de la chaîne, une roulette 316 avec une gorge en V pour le guidage du fil de bobinage vers le magasin 220.

Une potence 302 est également fixée à la plaque verticale 202. La potence 302 est munie à son extrémité d'un crochet 304 permettant d'attacher une extrémité du fil de bobinage lors du démarrage de la séquence de bobinage du tore. Un système de contrepoids (non représenté) permet de conserver une certaine tension à l'extrémité du fil de bobinage. Grâce à ce système, la valeur de tension à l'extrémité du fil lors du démarrage du bobinage est répétable sur plusieurs séquences, dans la mesure où le même contrepoids est utilisé. Ce n'était pas le cas dans l'art antérieur, où l'extrémité du fil devait être tenue à la main par l'opérateur pendant l'opération de bobinage. Cette répétabilité permet d'obtenir de faibles dispersions en ce qui concerne la qualité de bobinage. Egalement, la sécurité de l'opérateur est préservée et le risque d'accident est réduit.

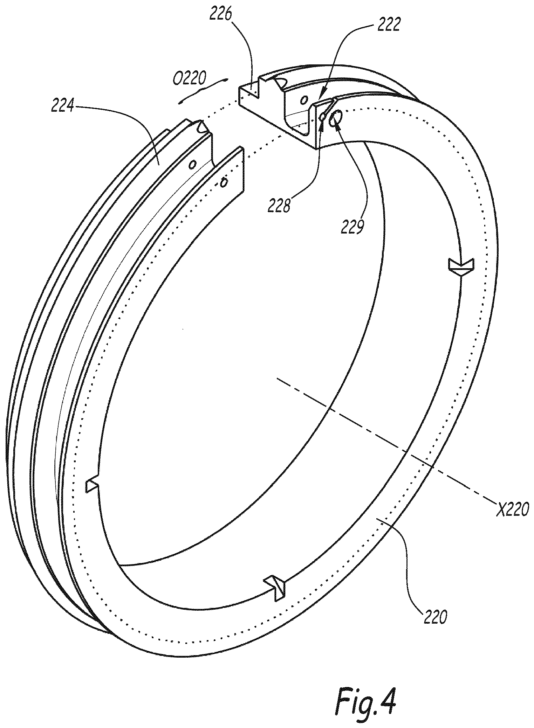

Comme visible à la figure 4, le magasin 220 est de forme annulaire, centrée sur un axe X220. Le magasin 220 ne s'étend pas sur toute la périphérie autour de l'axe X220, puisqu'il y a une ouverture permanente O220 entre les deux extrémités du magasin 220.

Le magasin 220 délimite une gorge périphérique 222 à section en U, formant un volume de stockage du fil de bobinage.

Le magasin comprend, sur l'un de ses flancs, une fente 228 en forme de sifflet et/ou un trou 229, pour attacher une extrémité du fil de bobinage. En fonction de la section du fil de bobinage utilisée et de la dextérité de l'opérateur, celui-ci pourra utiliser la fente 228 ou le trou 229 pour attacher le fil.

Le magasin 220 délimite un rebord périphérique 226 destiné à recevoir une couronne dentée (non représentée) et un profil de guidage en rotation. Le profil de guidage en rotation est formé par une nervure 224, qui s'étend sur tout le pourtour du magasin 220. On parle d'un guidage par l'extérieur. Avantageusement, la section de la nervure 224 est en forme de demi-lune.

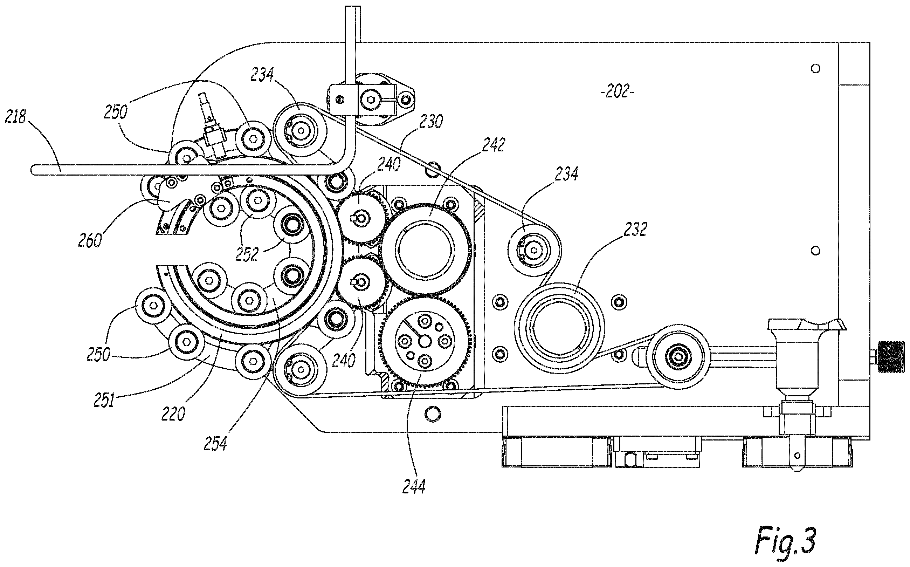

La tête de bobinage 200 comprend un mécanisme pour entrainer le magasin 220 en rotation autour de l'axe X220. Ce mécanisme est représenté à la figure 3 notamment. Il comprend deux pignons d'entraînement 240, destinés à coopérer avec les dentures de la couronne du magasin. Les deux pignons 240 sont entrainés par une roue motrice 242, disposant d'une denture complémentaire. Cette roue motrice est reliée à un premier moteur électrique (non visible sur les figures) disposé de l'autre côté de la plaque verticale 202. Un second moteur est prévu. Ce second moteur entraîne une roue dentée 244 qui est en engrenage avec la roue 242. Le premier et le second moteur sont pilotés en intensité.

Le second moteur agit sélectivement comme un frein. On parle d'un système maitre-esclave. Le premier moteur est dit « maitre », alors que le second moteur est dit « esclave ». Cet agencement permet une régulation plus fine de la tension mécanique du fil pendant le bobinage. Effectivement, il est connu que les moteurs électriques présentent à bas régime, c'est à dire à basse intensité, un fonctionnement qui n'est pas optimal. Ceci est dû notamment à des phénomènes de non-linéarité. Le moteur « esclave » permet donc de pouvoir utiliser la plage de fonctionnement optimale du moteur « maitre » en toutes circonstances, et notamment même lorsque le niveau de tension requis nécessite un faible couple moteur. Le bloc motorisation du magasin 220 comprend donc deux moteurs travaillant en couple différentiel. Le principe mécanique s'appuie sur la règle des 80/20 régissant le fonctionnement des moteurs. Un moteur a un couple linéaire quand on l'utilise sur 80% de sa plage. Entre 0 à 10% et 90 à 100%, les moteurs présentent des problématiques de linéarité. Par conséquent pour avoir un moteur le plus stable possible et donc linéaire, il faut l'utiliser à 50% de ses capacités. Dans notre cas, on souhaite réguler une tension entre 0 et 300 grammes. C'est pourquoi deux moteurs sont prévus : l'un maître et l'autre esclave, travaillant en couple différentiel pour générer la tension du fil par un delta de couple avec la motorisation du curseur.

Par exemple, à 75% de son échelle de fonctionnement, le moteur maître (curseur) délivre une tension de 400 grammes, la tension étant définie comme le produit du rayon du curseur, du couple moteur et du rapport de réduction moteur/curseur. Supposons que la tension souhaitée pendant le bobinage est de 180 grammes, alors le moteur esclave (magasin) devra générer un contre-effort de 220 grammes soit 41,5% de son échelle. De ce fait, les deux moteurs travaillent dans leur plage de confort garantissant un résultat le plus linéaire possible.

Comme visible à la figure 3, les moyens de guidage en rotation du magasin 220 comprennent une série de galets rotatifs 250, répartis sur la périphérie du magasin 220. Avantageusement, les galets 250 délimitent une gorge de section complémentaire à celle de la nervure 224. Dans l'exemple, ils sont emmanchés chacun autour d'un mandrin appartenant à une bague de support 251, qui est fendue.

Comme visible à la figure 3, la tête de bobinage 200 comprend un curseur 260 pour guider le fil de bobinage, en sortie du magasin 220, autour du tore à bobiner. Le curseur 260 est prévu pour effectuer une trajectoire circulaire autour de la section du tore à bobiner. Dans le présent document, lorsque l'on évoque la section du tore à bobiner, il s'agit évidemment de la section du tore dans un demi-plan dont l'axe central du tore peut être considéré comme une génératrice. En d'autres termes, chaque point de l'axe central du tore est inclus dans ce demi-plan. Cette section peut être circulaire, ovale, rectangulaire, etc.

De préférence, le curseur 260 et le magasin 220 sont fabriqués en impression 3D, notamment en titane car le titane présente une masse volumique relativement faible et un coefficient de ductilité très bas.

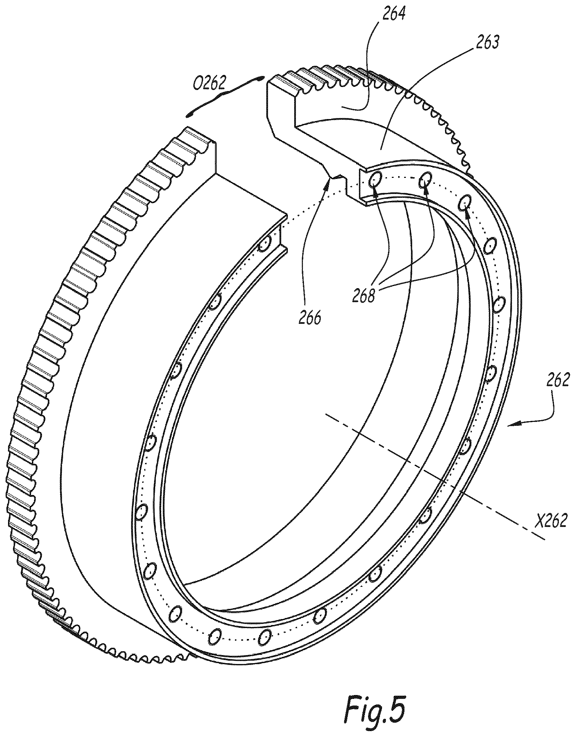

Le curseur 260 est fixé sur une roue porteuse 262, visible en particulier à la figure 5. Dans l'exemple, les moyens de fixation du curseur 260 sur la roue 262 incluent une pièce de fixation intermédiaire (non représentée) et des vis. Toutefois, cette pièce de fixation est optionnelle, dans le sens où le curseur 260 pourrait être fixé directement sur la roue 262.

Comme visible à la figure 5, la roue 262 est centrée sur un axe X262 et s'étend sur un secteur angulaire strictement inférieur à 360°. La roue 262 délimite effectivement une ouverture permanente O262 entre ses deux extrémités. Elle comprend une partie 264 à dentures et un cylindre 263, destiné à être engagé coaxialement à l'intérieur du magasin 220. Sur le flanc de la partie cylindrique 263 sont prévus des orifices 268 de réception de vis (non représentées) pour la fixation du curseur 260. Les orifices sont répartis sur toute la longueur curviligne de la roue 262, de façon à pouvoir fixer le curseur 260 n'importe où.

Le fait que la roue 262 et le magasin 220 délimitent chacun une ouverture permanente pour le passage du tore est particulièrement avantageux, et ce notamment lorsque le fil casse pendant le bobinage. Effectivement, avec les machines de l'art antérieur, et notamment avec la machine RWE Evolution de RUFF GmbH, en cas de casse de fil, il fallait débobiner manuellement et entièrement le magasin pour pouvoir accéder au tronçon amovible et ouvrir le magasin. Cela était très chronophage. Grâce aux ouvertures permanentes O220 et O262, respectivement du magasin et de la roue, lorsque le fil casse, il convient simplement, pour sortir le tore, de mettre les ouvertures O220 et O262 au même niveau et de couper la quantité de fil s'étendant entre les deux extrémités du magasin. Le tore peut alors être extrait rapidement en ouvrant la pince 3 doigts concentrique (décrite ci-après) qui porte le tore.

Egalement, à cause du jeu mécanique dans la liaison, le tronçon amovible de la machine RWE Evolution provoquait des vibrations lors du passage du curseur. De plus, le tronçon du magasin était parfois mal fermé par l'opérateur, ce qui pouvait entrainer des ouvertures intempestives pendant le cycle de bobinage. Enfin, le fonctionnement de la machine sans ce tronçon amovible était impossible du fait de l'entrainement en rotation du curseur au contact direct du magasin (le curseur était monté sur le magasin). Tous ces problèmes ont été résolus dans l'invention, qui n'utilise pas un tel tronçon de magasin amovible.

Comme visible à la figure 3, la roue 262 est guidée en rotation par une série de galets 252 disposés à l'intérieur de celle-ci. On parle d'un guidage par l'intérieur. Les galets 252 comprennent chacun une gorge coopérant avec une nervure périphérique 266 ménagée sur la surface radiale interne de la partie cylindrique 263. Avantageusement, la nervure 266 présente une section en forme de demi-lune.

Le mécanisme d'entrainement du curseur 260 en rotation est visible notamment à la figure 3. Ce mécanisme comprend une courroie crantée 230 coopérant avec la partie à dentures 264 de la roue 262. La courroie 230 est entrainée par une poulie motrice 232. Des poulies de renvoi 234 sont prévues pour guider la courroie 230 jusqu'à la partie à dentures 264 de la roue 262.

Le mécanisme d'entrainement du curseur 260 en rotation est distinct du mécanisme d'entrainement du magasin 220 en rotation, de façon que le magasin 220 et le curseur 260 peuvent être entrainés en rotation indépendamment l'un de l'autre. Cela permet, entre autres, d'ajuster précisément la valeur de tension pendant le bobinage en modifiant le différentiel de vitesse entre le magasin 220 et le curseur 260, la valeur de tension étant d'autant plus grande que le différentiel de vitesse est élevée.

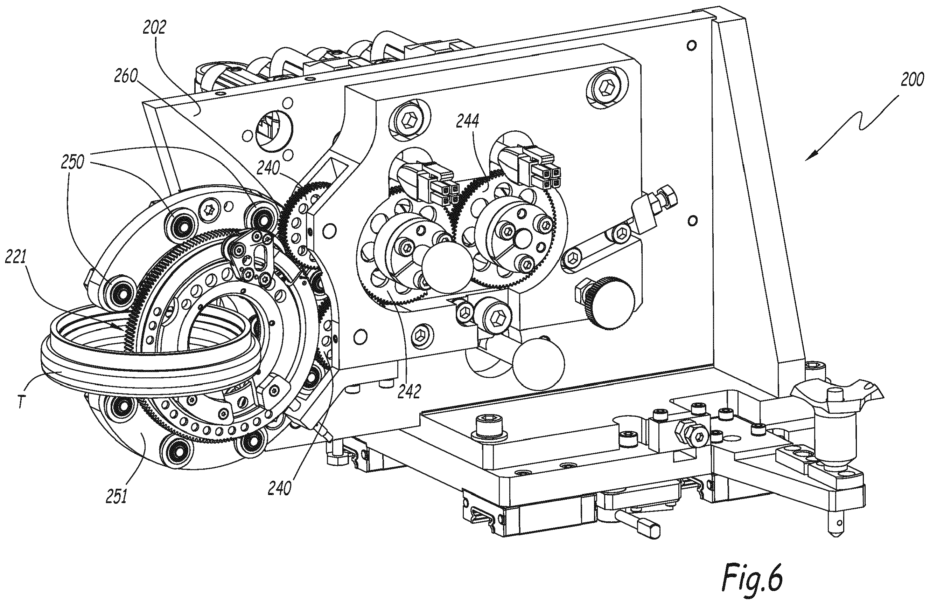

Sur la figure 6 est représentée une tête de bobinage selon un second mode de réalisation de l'invention. Dans ce qui suit, les éléments identiques ou comparables à ceux du premier mode de réalisation conservent leurs références numériques, alors que les autres éléments portent d'autres références numériques. Egalement, seules les différences par rapport au premier mode de réalisation sont mentionnées par souci de concision.

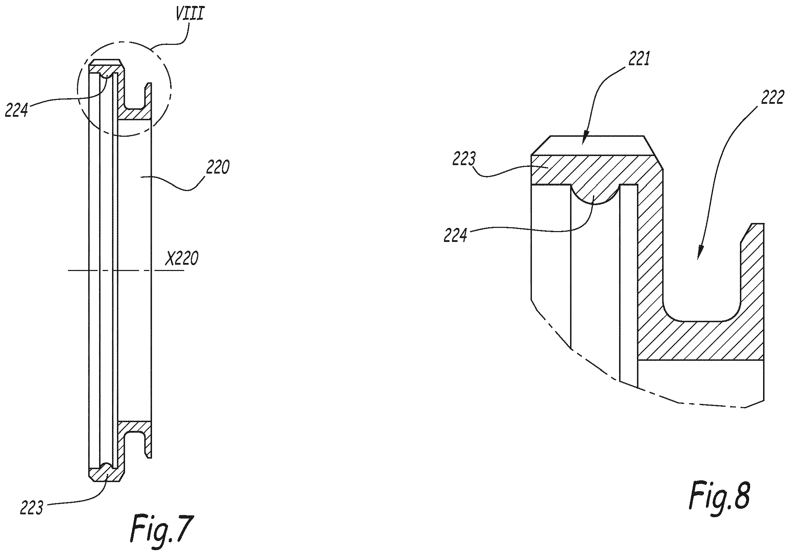

Dans le second mode de réalisation, et comme visible aux figures 7 et 8, le magasin 220 est guidé en rotation par l'intérieur et entrainé en rotation par l'extérieur. Il comprend une partie de guidage/d'entrainement 223, qui est cylindrique centrée sur l'axe X220. Cette partie cylindrique 223 comporte, sur sa surface radiale interne, une nervure périphérique 224, avec un profil en section qui est dans l'exemple en forme de demi-lune. Le magasin 220 ne comprend pas de roue dentée rapportée, dans le sens où tout est d'un seul tenant (monobloc) : la partie cylindrique 223 comporte, sur sa surface radiale externe, des dentures 221 pour l'entrainement en rotation.

Dans ce mode de réalisation, le guidage en rotation est effectué par l'extérieur, au moyen d'un roulement (non représenté). La roue 262 comprend une bande 266 de réception pour des éléments roulants (non représentés), tels que des billes ou des rouleaux. La roue 262 s'étend sur un secteur angulaire strictement inférieur à 360°. Elle délimite une ouverture O262 pour le chargement et déchargement du tore au centre du magasin 220.

Sur le flanc, la roue 262 délimite au moins un orifice 265 pour le vissage d'une roue crantée (non visible sur les figures) destinée à coopérer avec une courroie crantée comparable à celle du premier mode de réalisation. Notamment, la roue crantée est destinée à être montée sur un rebord cylindrique 261 de la roue 262.

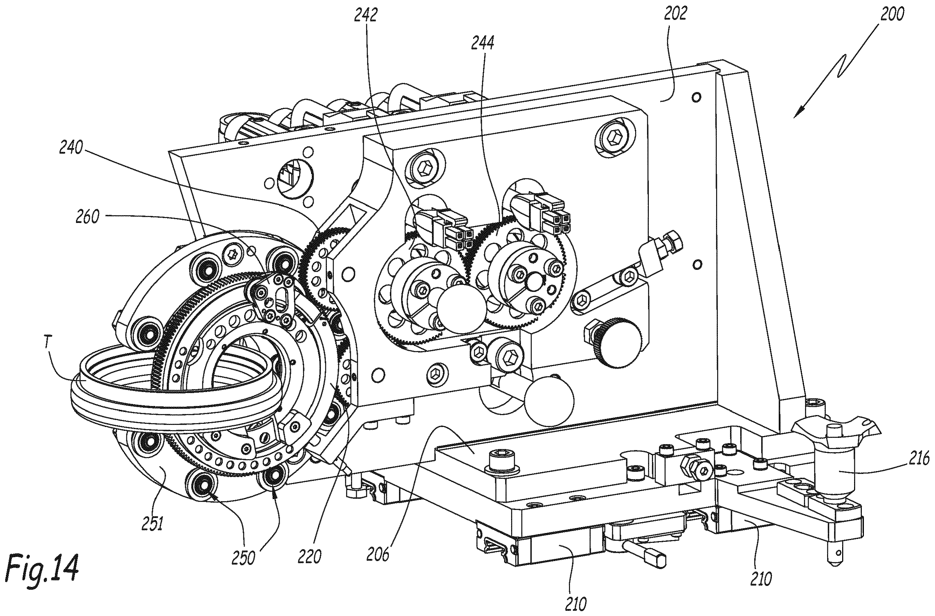

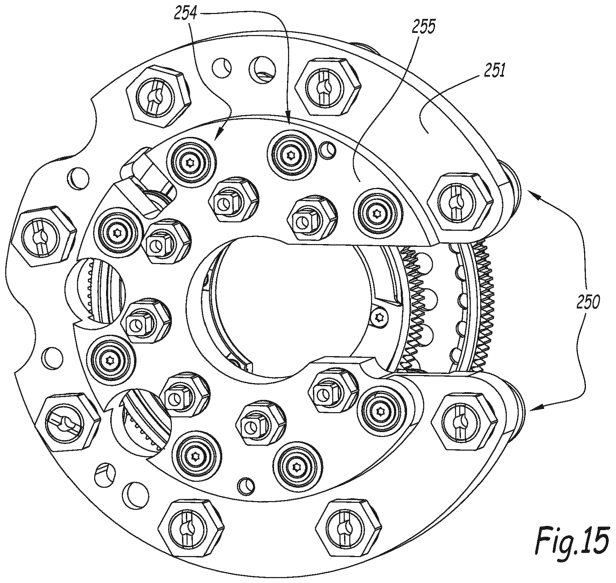

Sur les figures 14 à 16 est représenté un troisième et dernier mode de réalisation d'une tête de bobinage 200. Dans ce qui suit, seules les différences par rapport aux modes de réalisation précédents sont mentionnées. Les éléments comparables ou identiques conservent les mêmes références numériques, de nouvelles références numériques étant utilisées pour les autres.

La spécificité de ce troisième mode de réalisation concerne les composants utilisés pour le guidage du magasin 220 et de la roue porteuse 262 du curseur 260, l'objectif étant de proposer des moyens de guidage en rotation optimaux, et ce malgré la présence des zones d'ouverture permanente ménagées dans le magasin 220 et dans la roue porteuse 262.

En particulier, l'idée est d'assurer un guidage des pièces à la fois par l'intérieur et par l'extérieur. Ce principe porte un nom : il s'agit du guidage par contre-réaction.

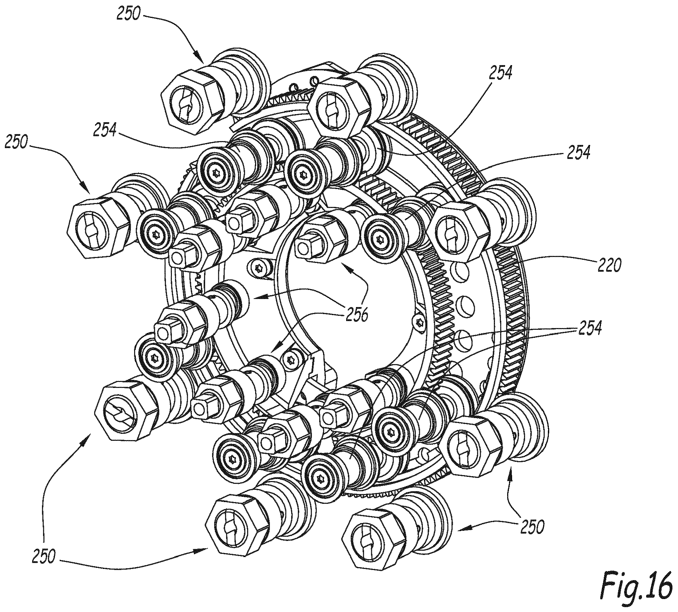

Comme visible à la figure 16, les moyens de guidage en rotation du magasin incluent des galets 250 dit « extérieurs », qui sont avantageusement au nombre de huit et qui sont répartis sur la périphérie autour du magasin, et des galets 254 dits « intérieurs », qui sont également prévus au nombre de huit et qui sont répartis sur le périmètre intérieur du magasin.

Ici, les galets 254 font également partie des moyens de guidage en rotation de la roue 262 porteuse du curseur 260. Ces moyens incluent également des galets 256, dits « intérieurs », qui sont avantageusement au nombre de 8 et qui sont répartis sur le périmètre intérieur de la roue porteuse 262.

De préférence, les galets 254 et 256 sont supportés par un même flasque 255, présentant également une ouverture permanente, comparable aux ouvertures O220 et O262.

Avantageusement, chaque galet est monté sur excentrique. Cela signifie que chaque galet peut être déplacé radialement sur une certaine course et donc que le diamètre de guidage des galets est réglable.

Indépendamment de ce qui précède, la table de bobinage 100 se distingue également clairement de l'état de l'art.

Dans l'art antérieur, et notamment dans la machine RWE Evolution de RUFF GmbH, la table de bobinage comprend un système de galets en polyuréthane, qui ont à la fois une fonction d'entrainement en rotation et une fonction de guidage. Dans cet exemple, les galets sont au nombre de trois. Chaque galet est monté sur un cylindre vertical, lequel est fixé à une extrémité d'une bielle articulée. De plus, chaque galet délimite une gorge périphérique en forme de C pour recevoir le tore. La position des galets est réglable en hauteur. Deux galets seulement sur les trois sont montés sur des cylindres motorisés, c'est-à-dire rotatifs. Le troisième galet, qui a donc une fonction de guidage uniquement, possède un degré de liberté supplémentaire, qui est un déplacement en translation. Ce troisième galet fait office de galet presseur. Il est déplacé lors des étapes de chargement du tore nu et de déchargement du tore bobiné.

Un inconvénient majeur de cette table de bobinage réside dans la difficulté à conserver la concentricité (ou coaxialité) lors d'un changement de diamètre de tore. En d'autres termes, il est difficile, lorsque l'on souhaite charger un tore plus grand ou plus petit que le tore précédent, de centrer le nouveau tore sur le même point que le tore précédent. Effectivement, cette opération est effectuée manuellement en déplaçant un à un les galets et peut prendre jusqu'à plusieurs heures, pour un résultat souvent approximatif. En outre, les dispersions de centrage des tores entrainent des disparités au niveau de la qualité de bobinage, c'est-à-dire des tores avec un pas de bobinage variable d'un tore à l'autre.

De tels problèmes ne se retrouvent pas dans la table de bobinage 100 de la machine de bobinage toroïdal M selon l'invention. Cette dernière permet de positionner le tore T plus facilement, notamment en cas de changement de diamètre et assure que chaque tore bobiné par la machine est centré à l'identique. Cette régularité en termes de centrage permet d'obtenir une qualité de bobinage équivalente pour plusieurs diamètres de tore, c'est-à-dire une bonne répétabilité de bobinage.

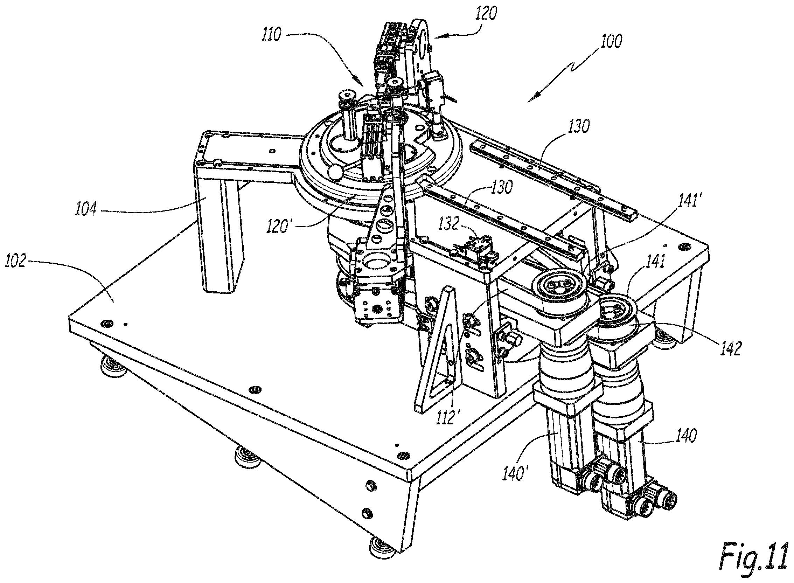

Effectivement, comme visible à la figure 11, la table de bobinage 100, appartenant à la machine de bobinage toroïdal M, comprend des moyens 110 de support et de guidage en rotation du tore T et des moyens 120, 120' d'entrainement du tore T en rotation qui sont distincts des moyens de guidage 110. Les moyens de support et de guidage 110 sont formés par une pince de préhension concentrique. Cette pince est supportée par des pieds 104 s'étendant à partir du support 102.

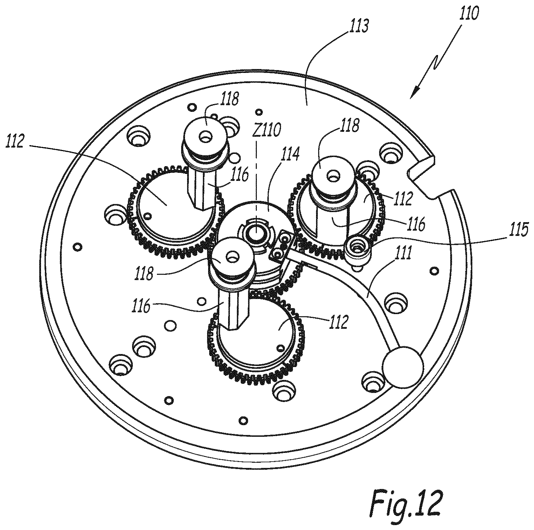

De préférence, et comme visible à la figure 12, la pince de préhension concentrique 110 comprend trois galets 118 disposés de sorte que chaque galet 118 reste en permanence équidistant des deux autres galets et d'un axe central Z110. On parle couramment d'une « pince trois doigts concentrique ».

Avantageusement, chaque galet 118 est monté sur un cylindre 116 fixé de manière excentrée sur un pignon rotatif 112. Chaque galet 118 comprend une partie creuse sensiblement en forme de V pour recevoir le tore T. Cette partie creuse, qui s'étend, à la manière d'une gorge, sur toute la périphérie du galet, présente un plan de symétrie perpendiculaire à un axe du galet. Ce profil de gorge symétrique permet de centrer automatiquement le tore T à l'intérieur de la pince concentrique 110, et donc d'éviter que le tore se positionne de travers entre les trois galets 118.

Dans l'exemple, tous les pignons rotatifs 112 sont en engrenage avec un pignon central 114, mobile autour de l'axe Z110. L'axe Z110 est confondu avec l'axe central du tore lorsque le tore est positionné à l'intérieur de la pince. La rotation du pignon central 114 entraine la rotation de chaque pignon 112, et par conséquent, le déplacement des galets 118 les uns par rapport aux autres. La construction de cette pince 110 est telle que les galets 118 restent automatiquement équidistants les uns des autres lorsqu'on tourne le pignon central 114. Dans l'exemple, un levier 111 permet de pivoter le pignon central 114 pour ouvrir plus ou moins la pince.

Avantageusement, les trois galets 118 sont mobiles entre une position d'ouverture minimale et une position d'ouverture maximale et sont rappelés en position d'ouverture minimale grâce à un système de contrepoids (non représenté) agissant sur le pignon central 114. Ainsi, lorsque le tore T est positionné à l'intérieur de la pince 110, celle-ci se referme automatiquement autour du tore. De préférence, une butée de fermeture 115 est prévue pour limiter la fermeture de la pince 110. Autrement formulé, la butée 115 définit une configuration d'ouverture minimale (ou de fermeture maximale), dans laquelle les galets 118 sont disposés au plus proche de l'axe central Z110.

Dans l'exemple, le système de contrepoids comprend un câble (non représenté), de préférence en acier, qui est enroulé autour du pignon central 114 et qui est guidé autour d'une ou plusieurs poulies de renvoi (non représentées) de façon à être attaché à une gueuse (non représentée) servant de contrepoids. Ce contrepoids présente l'avantage de générer des efforts radiaux équivalents au niveau des trois galets 118 pendant tout le cycle de bobinage.

La gueuse est formée par une tige filetée comprenant un crochet d'attache au câble et par au moins un poids vissé autour de la tige. La masse de la gueuse est avantageusement ajustée pendant le cycle de bobinage de façon à ouvrir la pince 110 et compenser l'augmentation de section du tore (du fait de l'enroulement du fil de bobinage). Le réglage de la masse est effectué par l'ajout de plaques d'acier tarées à 50g unitaire ou 1kg unitaire.

Astucieusement, les moyens d'entrainement du tore T en rotation comprennent au moins deux pinces 120 et 120', les deux pinces 120 et 120' étant mobiles en rotation dans un secteur angulaire respectif défini entre deux galets 118, de façon à pouvoir saisir et déplacer à tour de rôle le tore à bobiner T sur une course proportionnelle à l'espacement angulaire entre deux galets. Les pinces 120 et 120' peuvent être qualifiées de « pinces périmétriques ».

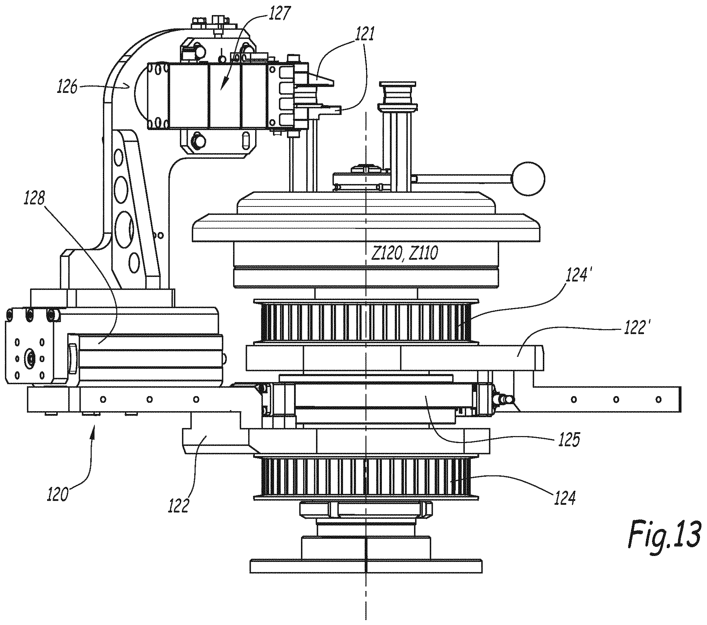

Chacune des pinces 120 et 120' est entrainée en rotation autour d'un axe Z120 par un système de poulie-courroie indépendant, dont une partie est visible à la figure 11. L'axe de rotation Z120 des pinces 120 et 120' est confondu avec l'axe central Z110 de la pince trois doigts, et avec l'axe du tore lorsque celui-ci est positionné à l'intérieur de la pince 110. Egalement, l'axe de rotation du tore T est confondu avec les axes Z110 et Z120. Les pinces 120 et 120' sont entrainées en rotation chacune grâce à un système d'entrainement indépendant. Le système d'entrainement de la pince 120 comprend un moteur électrique 140, une poulie 141, et une courroie dentée 142. Le moteur 140 entraine la poulie 141 et la poulie 142, qui est menante, transmet un couple mécanique à une poulie menée 124 (visible à la figure 13) par l'intermédiaire de la courroie dentée 142.

La pince 120' dispose de son propre système d'entrainement, lequel est sensiblement identique à celui de la pince 120. Il comprend un moteur électrique 140', une poulie menante 141' et une courroie dentée 142'. Le moteur 140' transmet un couple à la poulie 141', lequel est transmis à une poulie menée 124' via la courroie 142'. L'axe de rotation des poulies 124 et 124' est confondu avec l'axe Z120.

Un réducteur épicycloïdal et un roulement à rouleaux sont disposés en sortie de chaque moteur 140 et 140' de façon à encaisser les efforts radiaux (efforts centrifuges).

Dans ce qui suit, seule la pince 120 est décrite, la pince 120' étant identique. La pince 120 comprend ce qu'on appelle une raquette 122, qui est solidaire en rotation de la poulie 124. Une raquette 122' correspondante est prévue pour la pince 120'. La raquette 122' est solidaire en rotation de la poulie 124'. Les raquettes 122 et 122' sont prévues en métal.

Comme visible à la figure 13, la raquette 122 supporte un actionneur linéaire 128, du type vérin électrique, comprenant une partie fixe et une partie mobile. La partie mobile du vérin est déplaçable selon une direction radiale par rapport à l'axe Z120. Une partie en forme de col de cygne 126 est montée sur la partie mobile de l'actionneur linéaire 128. Cette partie en col de cygne 126 porte une pince électrique à mords parallèles équipée de deux mords 121 adaptés à la géométrie du tore à bobiner T. Les mords 121 sont parallèles et sont mobiles l'un en direction de l'autre, de façon à pouvoir saisir des tores de différents gabarits. A cet effet, une table micrométrique 127, servant d'interface mécanique entre la partie en forme de col de cygne 126 et les mords 121, permet d'ajuster la position en hauteur des mords 121.

La table de bobinage comprend un système pour asservir la position angulaire du tore pendant l'opération de bobinage. Ce système comprend dans l'exemple un moyen de mesure sous la forme d'un codeur rotatif incrémental 125, qui est avantageusement monté directement autour de l'arbre central (non représenté) solidaire des raquettes 122 et 122'. Notamment, le codeur est interposé entre les raquettes 122 et 122' pour garantir le niveau de précision le plus élevé.

Le déplacement des pinces 120 et 120' est commandé par un processeur dédié, capable de gérer le déplacement angulaire des pinces (position de départ, position de fin de course, vitesse angulaire, etc.) et les séquences d'ouverture et de fermeture des mords 121.

Pour assurer un bobinage qualitatif et répétable, la section du tore à bobiner est avantageusement positionnée au centre du magasin 220. Ainsi, lors d'un changement de diamètre, il est nécessaire de repositionner la tête de bobinage 200 par rapport à la table 100. Comme visible à la figure 11, la table de bobinage 200 comprend donc deux rails 130, qui sont des rails profilés à recirculation de billes et à forte capacité de charge. Ces rails 130 sont configurés pour le guidage des patins 210 de la tête de bobinage 200. On parle d'un réglage en profondeur de la tête de bobinage 200 par rapport à la table de bobinage 100. Dans l'exemple, les moyens de réglage en profondeur 130 sont configurés pour déplacer la tête de bobinage 100 dans un plan radial à l'axe Z120 ou Z110 de rotation du tore T. Cela présente l'avantage que le fil est déposé dans ce même plan radial, et donc que les spires sont bien parallèles les unes aux autres.

Avantageusement, le fait de pouvoir reculer la tête de bobinage 200 par rapport à la table de bobinage 100 permet également d'intervenir plus facilement sur les composants de la tête 200 lors des opérations de maintenance et également lorsqu'il convient de procéder à certains réglages mécaniques.

Dans l'exemple, la machine M est conçue pour le bobinage de trois tores de diamètres différents. En variante, celle-ci pourrait être conçue pour un nombre de diamètre supérieur. La table de bobinage 100 comprend un dispositif d'indexation 132, visible uniquement à la figure 11, et permettant d'assurer un positionnement précis de la tête de bobinage 200 dans trois positions. Ce dispositif d'indexation 132 délimite trois logements de positionnement de la goupille 216. Le verrouillage de la goupille 216 dans l'un des trois logements détermine la position axiale de la tête de bobinage 200 le long des rails 130.

Avantageusement, le dispositif d'indexation 132 est pourvu de capteurs de détection de la goupille. Il y a un capteur de détection pour chaque logement. Ces capteurs permettent d'obtenir un retour d'information sur la position de la tête de bobinage 200 par rapport à la table 100 qui a été sélectionnée.

Dans chaque mode de réalisation, le bobinage d'un tore est effectué de la manière suivante.

Le magasin 220 est avancé jusqu'à ce que le centre du magasin 220 soit positionné précisément autour d'une section du tore. Un tore (nu) à bobiner est positionné à l'intérieur de la pince concentrique 110, et notamment entre les trois galets 118 de la pince. Pour cela, l'opérateur peut déplacer la tête de bobinage le long des rails 130, jusqu'à atteindre la position correspondant au diamètre du tore sélectionné.

Le magasin 220 est ensuite chargé avec la quantité de fil nécessaire au bobinage du tore. Pour ce faire, le fil de bobinage est tiré grâce au système 300 à partir d'une bobine mère, notamment une bobine de fil de cuivre. Une extrémité du fil de bobinage est ensuite attachée au magasin, par exemple au trou 229 ou à la fente en forme de sifflet 228 et le magasin est entrainé en rotation.

Le nombre de tours effectués par le magasin peut avantageusement être programmé en fonction du diamètre du tore à bobiner. Il peut également être calculé par rapport au nombre de spires à bobiner.

Le fil de bobinage est emmagasiné dans la gorge en U 222. Dès que la quantité de fil nécessaire au bobinage a été chargée, la rotation du magasin 220 est interrompue et l'opérateur coupe le fil, notamment grâce au système coupe-fil 312. La phase de chargement est terminée.

Ensuite, l'opérateur passe le fil à travers le canal de guidage du curseur, puis il effectue quelques tours morts autour d'un élément du tore à bobiner, cet élément pouvant être une broche (non représentée) ou une section du tore. Enfin, le fil est introduit à l'intérieur du système de guide fil 218 et l'extrémité du fil est accrochée au crochet 304 du système de suspente 302. Un lest (non représenté) est assemblé sur le système 302 de façon à mettre le fil de bobinage sous tension. En l'absence de broche, le fil de départ est maintenu tendu vers l'arrière de la machine. Le bobinage démarre et au bout d'une dizaine de spires, l'opérateur peut ramener le fil sur le crochet de la suspente et y attacher le contrepoids.

Le processus de bobinage peut alors commencer. L'opérateur programme les caractéristiques liées à la séquence de bobinage, comme le niveau de tension souhaité, le pas de bobinage, etc.

Le curseur est déplacé en rotation autour de la section du tore à bobiner et tire le fil stocké à l'intérieur du magasin. Le magasin est alors également entrainé en rotation par la consommation de fil réalisée, mais avec une vitesse moindre. La rotation du curseur entraine progressivement l'enroulement du fil de cuivre autour de la section du tore à bobiner.

En parallèle, le tore est déplacé en rotation autour de son axe, de manière synchronisée avec la rotation du curseur. En particulier, les pinces 120 et 120' viennent à tour de rôle saisir le tore pour le déplacer en rotation sur un secteur angulaire correspondant sensiblement à l'angle entre deux galets 118, soit 120°. La course des pinces 120 et 120' est d'autant plus importante que le diamètre du tore est élevé.

Une ou plusieurs couches de fils peuvent être appliquées autour du tore. Pour chaque couche, le tore peut effectuer un tour complet. Un segment programmé peut correspondre à une couche ou une partie de la couche (on peut être amené à décomposer une couche en plusieurs segments quand, par exemple, on veut générer une densité de bobinage différente sur le début ou la fin de couche, c'est-à-dire très localement). Chaque segment est défini par le sens de rotation du tore, le pas de bobinage utilisé, le nombre de spires, la vitesse, l'accélération (et décélération), la tension de bobinage et un stop (arrêt de la machine), par exemple en fin de segment. Les paramètres de chaque segment peuvent donc être modifiés à souhait, ce qui offre une certaine souplesse de programmation.

En variante non représentée, la courroie crantée 230 est remplacée par un ou plusieurs pignons d'entrainement. Notamment, le mécanisme d'entrainement du curseur 260 pourrait inclure deux petits pignons, interposés chacun entre deux galets 254. Un bloc moteur amovible pourra alors être utilisé pour entrainer les pignons.

Selon une autre variante non représentée, le nombre de galets de la pince concentrique 110 peut être supérieur à 3.

Les caractéristiques des variantes et modes de réalisation envisagés ci-dessus peuvent être combinées entre elles pour générer de nouveaux modes de réalisation de l'invention.

## Revendications

1. Machine de bobinage toroïdal, comprenant une tête de bobinage (200) et une table de bobinage (100), conçue pour supporter et mettre en rotation un tore (T) pendant une séquence de bobinage, la tête de bobinage comprenant :
- un magasin annulaire (220) pour stocker la quantité de fil nécessaire au bobinage d'un tore,
- un premier mécanisme (240, 242, 244) pour entrainer le magasin en rotation, et
- un curseur (260) pour guider le fil, en sortie du magasin, autour du tore, la tête de bobinage comprenant un second mécanisme (230, 232, 234), distinct du premier mécanisme, pour entrainer le curseur en rotation, de façon que le magasin et le curseur peuvent être entrainés en rotation indépendamment l'un de l'autre et **caractérisé en ce que** le curseur (260) est fixé sur un flanc d'une roue (262) montée coaxialement à l'intérieur du magasin.

2. Machine selon la revendication 1, **caractérisée en ce que** la table de bobinage comprend des premiers moyens (110) de support et de guidage en rotation du tore (T) et des seconds moyens (120, 120') d'entrainement du tore (T) en rotation distincts des premiers moyens et **en ce que** les premiers moyens (110) sont formés par une pince de préhension concentrique.

3. Machine selon la revendication 2, **caractérisée en ce qu'**un axe de rotation du tore (T) est confondu avec un axe central (Z110) de la pince de préhension concentrique (110).

4. Machine selon l'une des revendications précédentes, **caractérisée en ce que** la table de bobinage (100) comprend des moyens (130) de réglage en profondeur de la tête de bobinage (200).

5. Machine selon la revendication 4, **caractérisée en ce que** les moyens de réglage en profondeur (130) sont configurés pour déplacer la tête de bobinage (100) dans un plan radial à un axe (Z120, Z110) de rotation du tore (T).

6. Machine selon l'une des revendications précédentes, **caractérisée en ce que** le magasin (220) et la roue (262) sont centrés sur un même axe et s'étendent sur un secteur angulaire inférieur à 360° et définissent ainsi une ouverture permanente (O220, O262) pour le passage du tore.

7. Machine selon l'une des revendications précédentes, **caractérisée en ce qu'**elle comprend des premiers moyens de guidage (250 ; 250, 254), pour guider le magasin en rotation et des seconds moyens de guidage (252 ; 254, 256), distincts des premiers moyens de guidage, pour guider la rotation du curseur.

8. Procédé de bobinage d'un tore (T) au moyen d'une machine selon la revendication 2, le procédé comprenant des étapes consistant à
a) positionner le tore (T) à l'intérieur de la pince de préhension concentrique,
b) déplacer la tête de bobinage (200) jusqu'à atteindre une position où une section du tore à bobiner est sensiblement au centre d'un cercle décrit par le curseur (260),
c) utiliser les seconds moyens d'entrainement du tore (T) pour faire tourner le tore, et
d) déplacer le magasin (220) et le curseur (260) en rotation autour de la section du tore, de façon à débobiner du fil stocké dans le magasin autour de la section du tore.

## Patentansprüche

1. Ringbewickelmaschine, die einen Wickelkopf (200) und einen Wickeltisch (100) umfasst, der ausgebildet ist, einen Torus (T) bei einer Wickelsequenz zu lagern und in Drehung zu versetzen, wobei der Wickelkopf umfasst:
- ein ringförmiges Magazin (220), um eine für das Wickeln eines Torus notwendige Drahtmenge zu bevorraten,
- einen ersten Mechanismus (240, 242, 244) zum Antreiben des Magazins zur Drehung und
- einen Schieber (62), um am Ausgang des Magazins den Draht um den Torus herum zu führen,
wobei der Wickelkopf einen zweiten Mechanismus (230, 232, 234), unterschiedlich zum ersten Mechanismus, zum Antreiben des Schieber zur Drehung umfasst, derart, dass das Magazin und der Schieber zur Drehung unabhängig voneinander angetrieben werden können, **dadurch gekennzeichnet, dass** der Schieber (260) an einer Seitenwand eines Rades (262) befestigt ist, das koaxial im Inneren des Magazins montiert ist.

2. Maschine nach Anspruch 1, **dadurch gekennzeichnet, dass** der Wickeltisch erste Mittel (110) zum Abstützen und Führen des Torus (T) zur Drehung und zweite Mittel (120, 120') zum Antreiben des Torus (T) zur Drehung, unterschiedlich zu den ersten Mitteln, umfasst und dass die ersten Mittel (110) durch eine konzentrischen Greiferzange gebildet werden.

3. Maschine nach Anspruch 2, **dadurch kennzeichnet, dass** eine Drehachse des Torus (T) mit einer Mittelachse (Z110) der konzentrischen Greiferzange (110) übereinstimmt.

4. Maschine nach einem der vorhergehenden Ansprüche, **dadurch gekennzeichnet, dass** der Wickeltisch (100) Mittel (130) zum Einstellen des Wickelkopfes (200) hinsichtlich der Tiefe umfasst.

5. Maschine nach Anspruch 4, **dadurch gekennzeichnet, dass** die Mittel (130) zur Tiefeneinstellung ausgebildet sind, den Wickelkopf (100) in einer Ebene radial zu einer Drehachse (Z120, Z110) des Torus (T) zu bewegen.

6. Maschine nach einem der vorhergehenden Ansprüche, **dadurch gekennzeichnet, dass** das Magazin (220) und das Rad (262) auf eine selbe Achse zentriert sind und sich über einen Winkelsektor kleiner als 360° erstrecken und so eine ständige Öffnung (O220, O262) für den Durchgang des Torus definieren.

7. Maschine nach einem der vorhergehenden Ansprüche, **dadurch gekennzeichnet, dass** sie erste Mittel (250; 250, 254) zum Führen des Magazins zur Drehung und zweite Mittel (252; 254, 256) zum Führen, unterschiedlich zu den ersten Mitteln zum Führen, um die Drehung des Schiebers zu führen, umfasst.

8. Verfahren zum Wickeln eines Torus (T) mittels einer Maschine nach Anspruch 2, wobei das Verfahren die Schritte umfasst, die darin bestehen
a) Positionieren des Torus (T) innerhalb der konzentrischen Greiferzange,
b) Bewegen des Wickelkopfes (200) bis eine Position erreicht ist, in der ein Abschnitt des zu bewickelnden Torus im Wesentlichen in der Mitte eines von dem Schieber (260) beschriebenen Kreises angeordnet ist,
c) Benutzen der zweiten Mittel zum Antreiben des Torus (T), um den Torus zu drehen, und
d) Versetzen des Magazins (220) und den Schieber (260) in Drehung um den Abschnitt des Torus, um den im Magazin bevorrateten Draht um den Abschnitt des Torus herum abzuwickeln.

## Claims

1. Toroidal winding machine, comprising a winding head (200) and a winding table (100) designed to support and set in rotation a torus (T) during a winding sequence, the winding head comprising:
- an annular magazine (220) for storing the amount of wire necessary for winding a torus,
- a first mechanism (240, 242, 244) for driving the magazine in rotation, and
- a guide (260) for guiding the wire, at the exit of the magazine, around the torus, the winding head comprising a second mechanism (230, 232, 234), different from the first mechanism, for driving the guide in rotation, so that the magazine and the guide can be driven in rotation independently of one another, and **characterised in that** the guide (260) is fixed to a flank of a wheel (262) mounted coaxially inside the magazine.

2. Machine according to claim 1, **characterised in that** the winding table comprises first means (110) for supporting and guiding in rotation the torus (T) and second means (120, 120') for driving the torus (T) in rotation that are different from the first means, and **in that** the first means (110) are formed by concentric gripping tongs.

3. Machine according to claim 2, **characterised in that** an axis of rotation of the torus (T) is coincident with a central axis (Z110) of the concentric gripping tongs (110).

4. Machine according to any one of the preceding claims, **characterised in that** the winding table (100) comprises means (130) for adjusting the depth of the winding head (200).

5. Machine according to claim 4, **characterised in that** the means for adjusting the depth (130) are configured to displace the winding head (100) in a plane radial to an axis (Z120, Z110) of rotation of the torus (T).

6. Machine according to any one of the preceding claims, **characterised in that** the magazine (220) and the wheel (262) are centred on the same axis and extend over an angular sector of less than 360° and thus define a permanent opening (O220, O262) for passage of the torus.

7. Machine according to any one of the preceding claims, **characterised in that** it comprises first guide means (250; 250, 254), for guiding the magazine in rotation, and second guide means (252; 254, 256), different from the first guide means, for guiding the rotation of the guide.

8. Method for winding a torus (T) by means of a machine according to claim 2, the method comprising steps consisting in
a) positioning the torus (T) inside the concentric gripping tongs,
b) displacing the winding head (200) until it reaches a position in which a section of the torus to be wound is substantially at the centre of a circle described by the guide (260),
c) using the second means for driving the torus (T) to rotate the torus, and
d) displacing the magazine (220) and the guide (260) in rotation about the section of the torus, so as to unwind the wire stored in the magazine around the section of the torus.
